# EUROPEAN PATENT APPLICATION

(11) **EP 4 572 044 A1**
(43) Date of publication of application: **18.06.2025**
(21) Application number: 23216160.4
(22) Date of filing: 13.12.2023
(51) Int. Cl.: H02B 1/56, H05K 7/20

(54) **COOLING SYSTEM FOR ELECTRICAL ENCLOSURES**

(71) Applicant: ABB Schweiz AG, 5400 Baden (CH)
(72) Inventor: Molitor, Francoise, 8057 Zürich (CH); Sologubenko, Oleksandr, 8906 Bonstetten (CH); Torresin, Daniele, 5400 Baden (CH); Agostini, Bruno, 8006 Zürich (CH)
(74) Representative: De Bortoli, Eros

(57) **Abstract**

An electrical enclosure (1) which comprises a base wall (2), a top wall (3) and a plurality of lateral walls (4, 5, 6, 7) which define an internal volume (8) of said enclosure (1). The electrical enclosure (1) further comprises a thermal exchange device (10) which in turn comprises a first thermal exchange assembly (11) positioned in said internal volume (8), wherein the first thermal exchange assembly (11) comprises a first heat sink (110) and a first duct (12) having an inlet opening (121) and an outlet opening (122). The first heat sink (110) is fitted in the inlet opening (121) of said first duct (12), the first heat sink (110) is attached on one of said lateral walls (4, 5, 6, 7) in an upper half portion of the internal volume (8) of said enclosure (1), and the first duct (12) is directed downwardly with his outlet opening (122) positioned in a lower half portion of the internal volume (8) of said enclosure (1).

## Description

The present invention relates to an electrical enclosure provided with an innovative cooling system. In particular, the present invention relates to an electrical enclosure, such as, for example, a control cabinet or an electrical switchgear - more in particular a gas insulated switchgear - which is provided with an improved cooling system comprising a heat sink and a duct properly positioned inside the enclosure.

It is known that electrical equipment and apparatuses - e.g., switching apparatuses, transformers, bus-bars and similar devices - are typically housed within an enclosure to ensure safety and, for gas insulated system, to provide the requested insulation.

One of the major problems which is involved in the design of electrical enclosures is given by the need of dissipating the heat generated by the equipment housed in the enclosure during operation.

In practice, for electrical enclosures, e.g., switchgear systems in general, a proper thermal management is always a major challenge, since during operation the power losses produces waste heat, which must be kept under control in order to achieve the desired nominal current rating. In other words, the systems are thermally limited, meaning that the current ratings are limited by the temperature limits along the current path.

For gas insulated switchgear systems, this is especially challenging, as the current path is in a sealed enclosure. This leads to very high gas temperatures inside the compartment. Therefore, a reduction of the gas temperature has a big potential for improvement of the thermal situation, as it directly translated in reduced conductor temperatures.

Many attempts and proposals have been made in order improve the cooling of electrical enclosures, and in particular of gas insulated switchgear systems, so as to maintain the temperature of the apparatuses inside the enclosures at or below a desired threshold temperature.

The proposed solutions, which in general include passive or active cooling solutions, however, are not always completely satisfactory in terms of efficiency, structural simplicity and compactness and industrial costs and reliability / lifetime.

The main aim of the present invention is to provide an electrical enclosure, in particular a control cabinet or an electrical switchgear, more in particular a gas insulated switchgear, which allows overcoming or at least mitigating the drawbacks of the known art.

Within this aim, a purpose of the present invention is to provide an electrical enclosure, in particular a gas insulated switchgear, which is provided with an efficient system for decreasing the temperature inside the enclosure.

A further purpose of the present invention is to provide an electrical enclosure, in particular a gas insulated switchgear, in which an effective circulation and movement of gas inside the enclosure is maintained.

A further purpose of the present invention is to provide an electrical enclosure, in particular a gas insulated switchgear, provided with a cooling system substantially of passive type.

A further purpose of the present invention is to provide an electrical enclosure, in particular a gas insulated switchgear, which allows decreasing the thermal resistance between the enclosure wall(s) and the ambient air.

A further purpose of the present invention is to provide an electrical enclosure, in particular a gas insulated switchgear, which has a relatively simple construction, is easy and cheap to be manufactured at industrial levels, is easy and cheap to be maintained.

The above aim and purposes, as well as other purposes that will emerge clearly from the following description and attached drawings, are provided, according to the invention, by an electrical enclosure, according to the following claim 1 and the related dependent claims.

In further aspects, the present invention also specifically relates to a gas insulated switchgear as described herein.

In a general definition of the invention, the electrical enclosure of the present disclosure comprises a base wall, a top wall and a plurality of lateral walls which define an internal volume of said enclosure, and further comprises an innovative and improved thermal exchange device. In particular, the electrical enclosure of the present is characterized in that the thermal exchange device comprises a first thermal exchange assembly which is positioned in said internal volume. In turn, the thermal exchange assembly comprises a first heat sink and a first duct having an inlet opening and an outlet opening, the first heat sink being fitted in the inlet opening of said first duct. Moreover, in the electrical enclosure of the present disclosure, the first heat sink is attached on one of said lateral walls in an upper half portion of the internal volume of said enclosure and the first duct is directed downwardly with his outlet opening positioned in a lower half portion of the internal volume of said enclosure.

In this way, as better described hereinafter, in the electrical enclosure of the present invention, the design of the first thermal exchange assembly, combined with the proper positioning of its more relevant component, i.e., the first heat sink and the first duct, allows obtaining an efficient air movement inside the enclosure, thereby greatly improving the cooling of the electrical equipment and components housed inside the enclosure.

For the purposes of the present invention, the terms "upper half portion" and "lower half portion" are meant to designate the geometrical upper and lower half portions of the internal volume of the enclosure when it is in the operating position.

The novel thermal exchange device of the invention is therefore an efficient cooling system for gas insulated switchgear systems as well as, in general, for any sealed enclosures with power losses inside, as it helps decreasing the temperature of the gas inside the enclosure and driving gas circulation inside the system. The gas inside the system can be air at ambient or increased pressure, or any another gas or mixture of gases normally use in these applications.

In the following detailed description, the invention will be described with reference to a gas insulated switchgear but, in general, it can be applied to any gas or air-filled enclosures with power losses inside and with the need of removing heat therefrom.

In practice, in the thermal exchange device of the invention the first duct acts as a chimney combined the first heat sink. Differently from the normal applications of this kind of heat sink/chimney combination - which can be used, e.g., for cooling hotspots and in which the heat sink has a temperature higher than the surrounding gas - in the presently disclosed enclosure the heat sink is attached to the inside of an enclosure wall and has therefore a temperature lower than the surrounding gas temperature. The gas entering into the first heat sink is therefore cooled down at the contact with the heat sink, its density increases, and consequently it moves downward through the downwardly oriented first duct.

Indeed, it has been found that the design and the proper positioning of the first thermal exchange assembly (which is based on the combination of heat sink/downwardly oriented duct), brings about the two-fold advantage of reducing the average gas temperature inside the enclosure and inducing a gas flow due to the chimney effect in the internal volume of the enclosure, thereby further improving cooling of the electrical equipment and components housed inside the enclosure.

At the same time, the design of the thermal exchange device is relatively simple and the electrical enclosure of the present invention is therefore relatively easy to obtain from a manufacturing standpoint. In practice, in the simplest and more general implementation of the thermal exchange device, a heat sink is attached at the top region of one of the side walls of the enclosure and it is at least partially enclosed by the duct pointing downwards and creating the chimney effect.

Moreover, it is worth noting that the thermal exchange device used in the enclosure of the present invention is completely of the passive type, i.e., the air circulation effect is autonomously and automatically generated by the structure of the components of the thermal exchange assembly, without requiring dedicated power consuming equipment, e.g., forced air ventilation systems or similar systems.

In general, the first heat sink may be normally made from a thermally conductive material, typically aluminum, and the first duct is normally made with a material having a low thermal conductivity, typically plastic. However, other materials can be used according to the needs and the state of the art.

In addition, structures to guide the gas flow inside the first duct - such as, flaps, flux deviators, or similar flow direction control devices - can be attached to the inlet and /or outlet opening of the first duct.

According to some embodiments of the electrical enclosure of the invention, the first heat sink may be conveniently attached on a top portion of one of said lateral walls, i.e., in a top region of the internal volume of the enclosure where the gas temperatures are higher.

Moreover, at the same time, the first heat sink - and consequently the inlet opening of the first duct - may be conveniently positioned at a distance from the top wall of the enclosure, i.e., not too close to said top wall, so as not to hinder the gas inflow in the first heat sink and in the first duct.

In embodiments of the electrical enclosure of the present disclosure, the outlet opening of the first duct may be conveniently positioned in a bottom region of the internal volume of the enclosure, i.e., in a region of the internal volume of the enclosure where the gas temperatures are lower, so as to maximize the chimney effect.

Also in this case, the outlet opening of the first duct may be conveniently positioned at a distance from the base wall of the enclosure, i.e., not too close to said base wall, so as not to hinder the gas outflow from the first duct.

For the purposes of the present invention, the terms "top" and "bottom" are referred to the electrical enclosure or parts thereof when the enclosure is in the operating position.

According to general embodiments of the invention, the first thermal exchange assembly may preferably comprise a first thermal interface plate made of a thermal conductive material which is positioned between said first heat sink and the lateral wall onto which said first heat sink is attached, so as to improve thermal contact and thermal exchange between the first heat sink and the lateral wall of the electrical enclosure.

In typical embodiments of the presently disclosed electrical enclosure, the first heat sink may conveniently comprise a plurality of fins which are made of a thermal conductive material. Such fins are conveniently exposed to the inflow of the gas from the internal volume of the enclosure into the first duct, and may be positioned, e.g., on a thermal interface plate so as to perpendicularly protrude therefrom, the thermal interface plate being in turn attached on the lateral wall of the electrical enclosure. Other arrangement of the fins, e.g., parallel to the thermal interface plate, are also possible.

According to general embodiments of the electrical enclosure of the invention, the inlet opening of the first duct is tightly fitted around at least a portion of the first heat sink. For instance, in the above-described finned structure of the first heat sink, the gaps between the last fins and the first duct wall, and between the fin tips and the first duct wall, may be, e.g., at maximum about the fin spacings.

In general, the first heat sinks dimensions and characteristics - for instance the fins arrangement, spacing and thickness - may be optimized according to the needs and for given operating conditions (temperatures, kind of gas, ...).

According to some embodiments of the electrical enclosure of the invention, the thermal exchange device may conveniently comprise a second thermal exchange assembly which is positioned outside the electrical enclosure and which is in thermal exchange with the first thermal exchange assembly positioned inside the electrical enclosure.

With respect to the embodiments including only a thermal exchange assembly positioned inside the electrical enclosure, the implementation of a second thermal exchange assembly outside the electrical enclosure decreases the thermal resistance between the enclosure wall(s) and the ambient air, thereby improving the overall cooling effectiveness of the system.

In practice, in exemplary embodiments of this arrangements of the thermal exchange device used in the electrical enclosure of the invention, the second thermal exchange assembly may conveniently comprise a second heat sink and a second duct having an inlet opening and an outlet opening.

In such a case, said second heat sink may advantageously be attached on the outer surface of the lateral wall onto which the corresponding first heat sink is attached. In particular, the second heat sink may be conveniently attached in a position matching the position of said first heat sink, with the inlet opening of the second duct tightly fitted around at least a portion of the second heat sink. Then, the second duct is directed upwardly and its outlet opening may be conveniently positioned, e.g., at a height above the top wall of the electrical enclosure.

In other words, in these embodiments and as better described in the following detailed description, the second thermal exchange assembly uses the chimney effect in a reverse way with respect to the first thermal exchange assembly, since the second heat sink is warmer than the surrounding ambient air. As a consequence, the ambient air entering in the second heat sink from the inlet opening of the second duct is heated and has a lower density with respect to the surrounding air which is at lower temperature, and therefore the air flow in the second duct is directed upwardly towards the outlet opening of said second duct.

As in the previously described embodiments concerning the structure of the first thermal exchange assembly, also the second thermal exchange assembly may conveniently comprise a second thermal interface plate which is positioned between the second heat sink and the lateral wall onto which said second heat sink is attached. In this way, the thermal resistance in the system may be further reduced.

Moreover, as for the first heat sink, also the second heat sink may advantageously comprise a plurality of fins made of a thermal conductive material.

In some embodiments of the electrical enclosure of the invention, one of the lateral walls of said enclosure may be provided with an opening. In such a case, the first and the second heat sinks may be positioned on opposite sides of a common baseplate which is attached on the relevant lateral wall around said opening. In this way, the first heat sink protrudes through the opening in the lateral wall inside the internal volume of the enclosure, while the second heat sink remains outside. The common baseplate is positioned on the lateral wall so as to close said opening in a gas-tight way. With such embodiment, the thermal contact between both sides is further improved.

In further embodiments of the electrical enclosure, according to the present disclosure, a heat pipes-based system may be used to further ensure low thermal resistance between both sides of the enclosure.

In particular, in such a case, said first and/or second thermal exchange assembly may comprise a plurality of heat pipes which can be suitably arranged depending on the needs and the design of the first and second thermal exchange assemblies. Exemplary embodiments of possible arrangements will be given in the following detailed description.

The shape of the first and second ducts can be simple, e.g., a straight rectangular shape, but in general can also be more complex, depending on the operating needs.

For instance, in some embodiments of the presently disclosed electrical enclosure, the first duct of the first thermal exchange assembly may be at least partially positioned at a distance from the lateral wall onto which said first heat sink is attached in order to maximize the heat transfer area between the gas and the enclosure wall. In such a case, the first duct can be shaped in a such a way to leave a gap between the first duct and the lateral wall of the enclosure over a part of the first duct height or over the whole height of the first duct.

In further embodiments of the electrical enclosure of the present disclosure, the outlet opening(s) of said first and/or second duct(s) may have a narrower cross section with respect to the corresponding inlet opening(s). Such solution can be helpful in cases where the heat sink(s) and/or the duct(s) are relatively wide in order to avoid inflow of surrounding gas/air through the outlet opening(s).

Further features and advantages of the present invention will be more apparent from the description of preferred but not exclusive embodiments of the present invention, shown by way of examples in the accompanying drawings, wherein:
- Figure 1 is a perspective view in transparency of a first embodiment of an electrical enclosure, according to the present invention;
- Figure 2 is a partial section view of the first embodiment of the electrical enclosure represented in figure 1, showing a detail of the thermal exchange assembly comprising a heat sink used in such embodiment;
- Figure 3 is a perspective view in transparency of the first embodiment of the electrical enclosure represented in figure 1, showing the gas flows inside the enclosure;
- Figure 4 is a perspective view in transparency of a second embodiment of an electrical enclosure, according to the present invention;
- Figure 5 is a partial section view of the second embodiment of the electrical enclosure represented in figure 4, showing a detail of the thermal exchange assemblies comprising a heat sink used in such embodiment;
- Figure 6 is a side view of the second embodiment of the electrical enclosure represented in figure 4;
- Figure 7 is a side view of the second embodiment of the electrical enclosure represented in figure 4, showing the gas flows inside the enclosure inside and outside the enclosure;
- Figure 8 is a perspective view in transparency of a third embodiment of an electrical enclosure, according to the present invention;
- Figure 9 is a partial section view of the third embodiment of the electrical enclosure represented in figure 8, showing a detail of the thermal exchange assemblies comprising a heat sink used in such embodiment;
- Figure 10 is a perspective view of a first and second heat sinks used in a fourth embodiment of an electrical enclosure, according to the present invention;
- Figure 11 is a partial section view of a fourth embodiment of an electrical enclosure, according to the present invention, showing a detail of the thermal exchange assemblies comprising the heat sinks represented in figure 10;
- Figure 12 is a side view of a fifth embodiment of an electrical enclosure, according to the present invention.

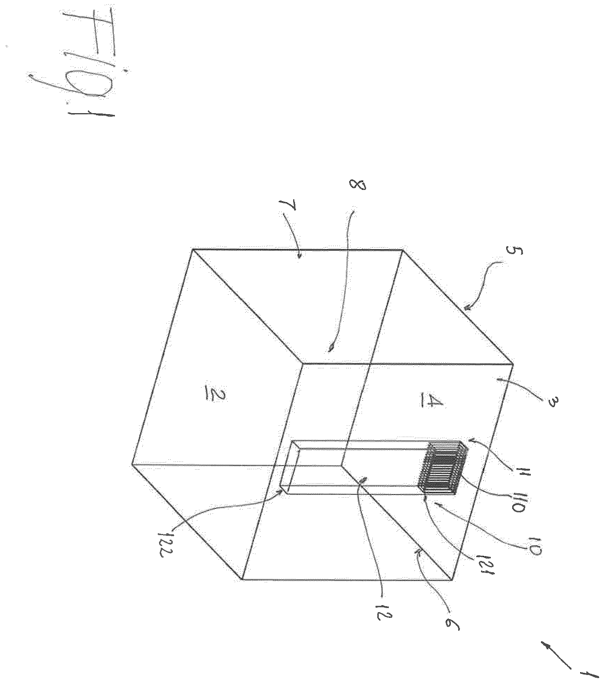

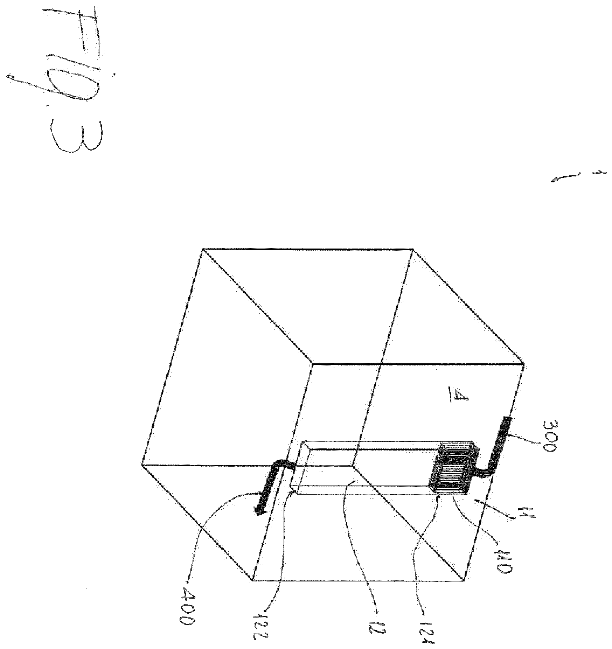

With reference to the attached figures, the present invention - in its more general definition as illustrated in figures 1 and 3 - relates to an electrical enclosure 1 which comprises a base wall 2, a top wall 3 and a plurality of lateral walls 4, 5, 6, 7 which delimit an internal volume 8 of the enclosure 1 into which a number of electrical apparatuses and equipment (not illustrated) can be housed.

Typically, the geometry of the enclosure is squared so as to allow the combination of different units to form a switchboard. Also, for certain applications, such as for instance in gas insulated switchgear, the various walls 2, 3, 4, 5, 6, 7 form a gas-tight enclosure into which a number of various electrical components are housed in a generally pressurized atmosphere of an insulating gas or mixture of gases.

The electrical enclosure 1 of the invention further comprises a thermal exchange device 10 which has the purpose of remove the heat - generally due to the power losses - generated into the internal volume 8 of the enclosure 1, as explained in the introductory part of the description. One of the peculiar features of the enclosure 1 of the invention is due to the characteristics, in particular the design and positioning, of the thermal exchange device 10.

In details, the thermal exchange device 10 comprises a first thermal exchange assembly 11 which is positioned into the internal volume 8. As shown in the attached figures, the first thermal exchange assembly 11 comprises a first heat sink 110 and a first duct 12 that is provided with an inlet opening 121 and an outlet opening 122. In the embodiments shown, the first duct 12 can in practice be a channel made of plastic material which is open towards the top 121 and the bottom 122, and is airtight on the sides.

The first heat sink 110 is fitted in the inlet opening 121 of the first duct 12 in a tight manner and is attached on one of the lateral walls 4, 5, 6, 7 of the enclosure 1 (the rear wall 4 in the figures). In the embodiments shown in the figures, the first heat sink 110 is attached to the rear wall 4 in an upper half-portion of the internal volume 8 of the enclosure 1 and the first duct 12 is directed downwardly so that his outlet opening 122 is positioned in a lower half portion of the internal volume 8 of said enclosure 1.

In this way, as previously explained and with particular reference to figure 3, a circulation of gas inside the enclosure 1 is generated by the gas entering into the first heat sink 110 from the inlet opening 121 as shown by the arrow 300 in figure 3. Due to the cooling of the gas when it comes into contact with the first heat sink 110 (which is at lower temperature), its density increases and consequently the gas moves downward through the first duct 12 and exit from the duct 12 through the outlet opening 122 as shown by the arrow 400.

In practice a circulation of gas inside the enclosure 1 is generated by the cooling of the gas itself into the first heat sink 110, which gas circulation - as previously explained - helps removing further heat from the electrical components and devices housed in the internal volume 8 of the enclosure 1.

With reference to the attached figures, the first heat sink 110 is attached on a top portion of one of said lateral walls 4, 5, 6, 7, e.g., the rear wall 4, not too close to the top wall 3 - i.e., at a distance from the top wall 3 - to avoid hindering the flow of the gas into the first duct 12 through the inlet opening 121.

Similarly, the outlet opening 122 of the first duct 12 is positioned in the bottom portion of the internal volume 8 of the enclosure 1 not too close to the base wall 2, so as not to hinder the free exit of the gas from first duct 12 through the outlet opening 122.

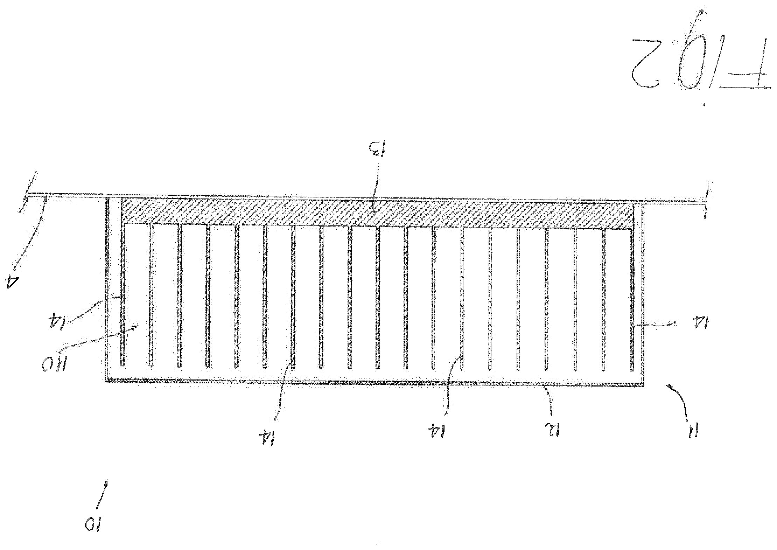

With reference to figure 2, in an exemplary embodiment of the invention, the first thermal exchange assembly 11 comprises a first thermal interface plate 13 made of a thermally conductive material which is positioned between the first heat sink 110 and the lateral wall 4, 5, 6, 7 e.g., the rear wall 4, onto which the first heat sink 110 is attached, to improve the thermal contact and the thermal exchange between the first heat sink 110 and the lateral wall 4 of the electrical enclosure 1.

Always with reference to figure 2, in the embodiment shown, the first heat sink 110 comprises a plurality of fins 14 which are made of a thermal conductive material, e.g., aluminium. As shown in figure 3, the fins 14 are exposed to the inflow of the gas into the duct 12 through the inlet opening 121 and are positioned on the thermal interface plate 13 which is in turn attached on the lateral wall 4 of the electrical enclosure 1. In this way the heat transfer from the relatively warm gas to the relatively colder outside ambient can be greatly enhanced.

In the embodiment of figure 2, the fins 14 protrude perpendicularly from the thermal interface plate 13. Other arrangements of the fins 14, e.g., parallel to the thermal interface plate 13, are also possible, depending on the needs and the design of the heat sink.

In general, the inlet opening 121 of the first duct 12 is tightly fitted around a portion of the first heat sink 110. In practice, as shown in figure 2, the distance of the walls of the duct 12 from the lateral fins 14 and from the tip of the fins 14 is minimal and is general lower than the pitch of the fins 14 positioned on the thermal interface plate 13.

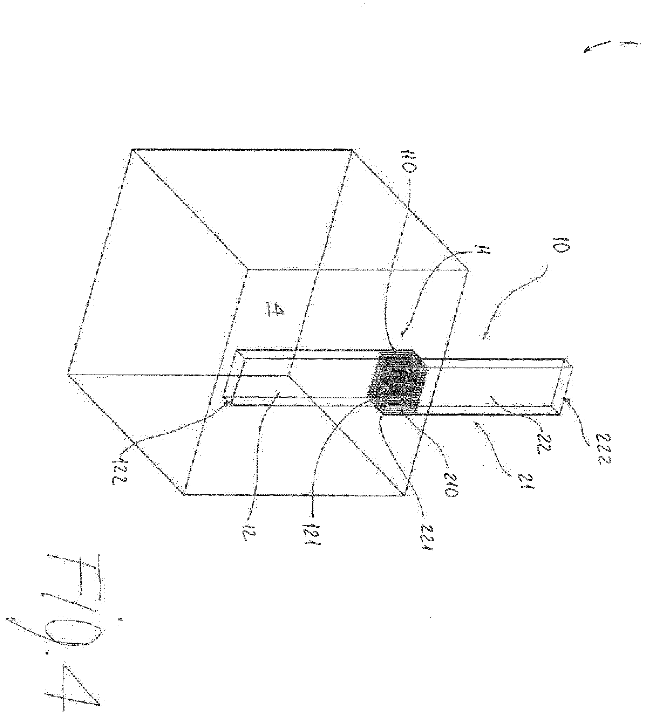

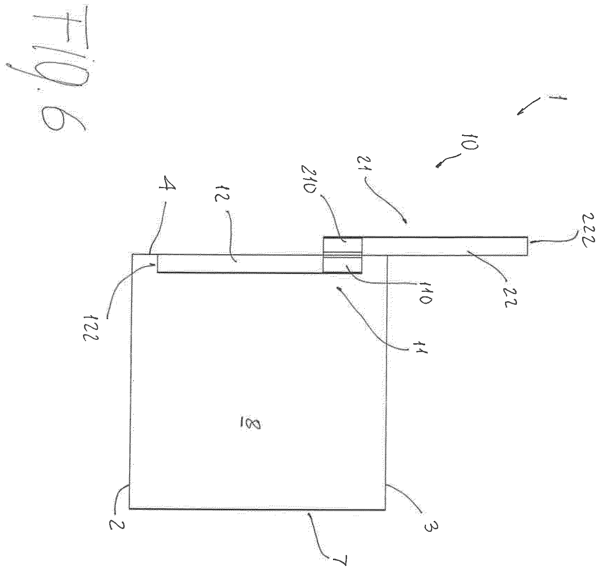

With particular reference to figures 4-7, in embodiments of the electrical enclosure 1 of the invention, the thermal exchange device 10 comprises a second thermal exchange assembly 21 which is positioned outside the electrical enclosure 1 and which is in thermal exchange with the first thermal exchange assembly 11.

In particular, the second thermal exchange assembly 21 comprises a second heat sink 210 and a second duct 22 that is provided with an inlet opening 221 and an outlet opening 222. The second duct 22 can in practice be a channel made of plastic material which is open towards an inlet 121 and outlet 122 extremes, and is airtight on the sides.

The second heat sink 210 is attached on the outer surface of the lateral wall 4, 5, 6, 7 onto which said first heat sink 110 is attached - e.g., the rear wall 4 in the embodiment shown in the figures - in a position matching the position of said first heat sink 110 in the inner surface of, e.g., the rear wall 4.

The inlet opening 221 of the second duct 22 tightly fitted around at least a portion of the second heat sink 210. Then, the second duct 22 is directed upwardly and its outlet opening 222, in the embodiment shown, is positioned over the enclosure 1, i.e., at a height above the top wall 3 of the electrical enclosure 1.

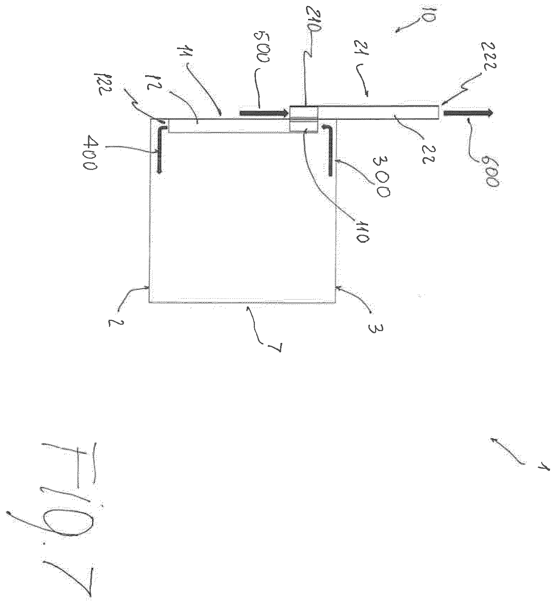

As shown in figure 7, in this embodiment the second thermal exchange assembly 21 uses the chimney effect in a reverse way with respect to the first thermal exchange assembly 11, as the second heat sink 210 is warmer than the surrounding ambient air. Therefore, the ambient air enters in the second heat sink 210 from the inlet opening 221 of the second duct 22, as shown by the arrow 500.

The air is heated in the second heat sink 210 and has a lower density with respect to the surrounding air which is at lower temperature. Consequently, the air flow in the second duct 22 is directed upwardly towards the outlet opening 222 of the second duct 22, from which it exits as shown by the arrow 600.

In practice, as clearly shown in figure 7, the first 110 and second 210 heat sink work in opposite way, the former being colder than the surrounding air (inside the enclosure 1) and generating an airflow directed downwards (as shown by arrows 300 and 400), the latter being warmer than the surrounding air (outside the enclosure 1) and generating an airflow directed upwards (as shown by arrows 500 and 600).

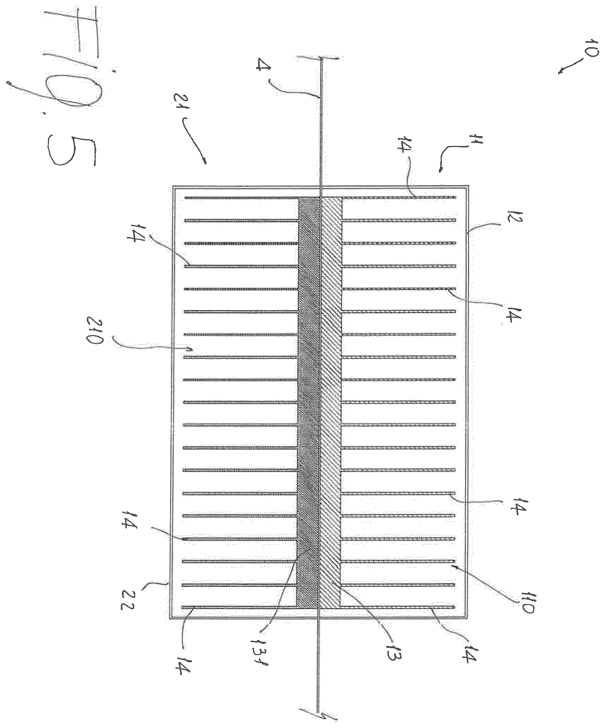

With reference to figure 5, in a further exemplary embodiment of the invention, the second thermal exchange assembly 21 comprises a second thermal interface plate 131 which is positioned between the second heat sink 210 and the lateral walls 4, 5, 6, 7 e.g., the rear wall 4, onto which the second heat sink 210 is attached.

In practice, as shown in figure 5, thermal interface plates 13 and 131 are positioned on both sides of, e.g., the rear enclosure wall 4, and consequently the thermal resistance in the system is further reduced.

In this case, as for the first heat sink 110, also the second heat sink 210 comprises a plurality of fins 14 which are made of a thermal conductive material, e.g., aluminium. The fins 14 of the second heat sink 210 are positioned on the thermal interface plate 131 which is in thermal exchange with the first heat sink 110 and receive heat from it. Then, the fins 14 of the second heat sink 210 are exposed to the inflow of the gas into the duct 22 through the inlet opening 221, thereby transferring heat to the relatively colder outside ambient air.

In the embodiment of figure 5, the fins 14 on both the first 110 and second 210 heat sinks protrude perpendicularly from the respective thermal interface plate 13 and 131. Other arrangement of the fins 14, e.g., parallel to the thermal interface plates 13 and 131, are also possible, depending on the needs and the design of the heat sinks.

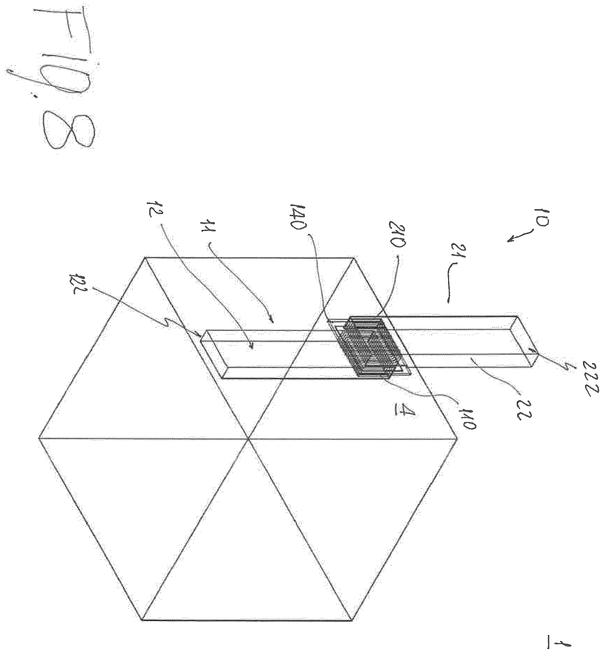

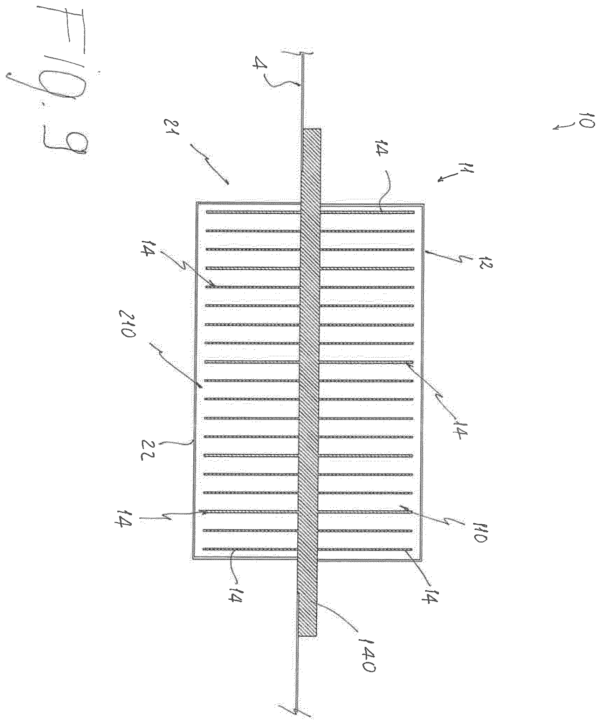

With reference to figures 8-11, in embodiments of the electrical enclosure 1 of the invention, one of the lateral walls 4, 5, 6, 7 of the enclosure 1, e.g., the rear wall 4, is provided with an opening. With particular refence to figure 9, in such embodiments the said first 110 and second 210 heat sinks are positioned on opposite sides of a common baseplate 140 which is attached on the relevant lateral wall, e.g., the rear wall 4, around said opening.

Then, the first heat sink 110 protrudes through the opening in the lateral wall, e.g., the rear wall 4, inside the internal volume 8 of the enclosure 1, while the second heat sink 210 remains outside. The common baseplate 140 is positioned on the lateral wall, e.g., the rear wall 4, so as to close said opening in a gas-tight way. As previously explained, with such embodiment, the thermal contact between both internal 8 and external sides of the enclosure 1 is further improved.

With reference to figure 9, also in this case, the first heat sink 110 and the second heat sink 210 comprises a plurality of fins 14 which are made of a thermal conductive material, e.g., aluminium. The fins 14 of both the first heat sink 110 and the second heat sink 210 are positioned on the common baseplate 140 on opposite sides thereof. In the embodiment of figure 9, the fins 14 on both the first 110 and second 210 heat sinks protrude perpendicularly from the common baseplate 140.

The fins 14 of the first heat sink 110 are exposed to the inflow of the gas into the duct 12 through the inlet opening 121 and transfer the heat to the fins 14 of the second heat sink 210 through the common baseplate 140. In turn, the fins 14 of the second heat sink 210 are exposed to the inflow of the ambient air into the duct 22 through the inlet opening 221, thereby transferring heat to the relatively colder outside ambient air.

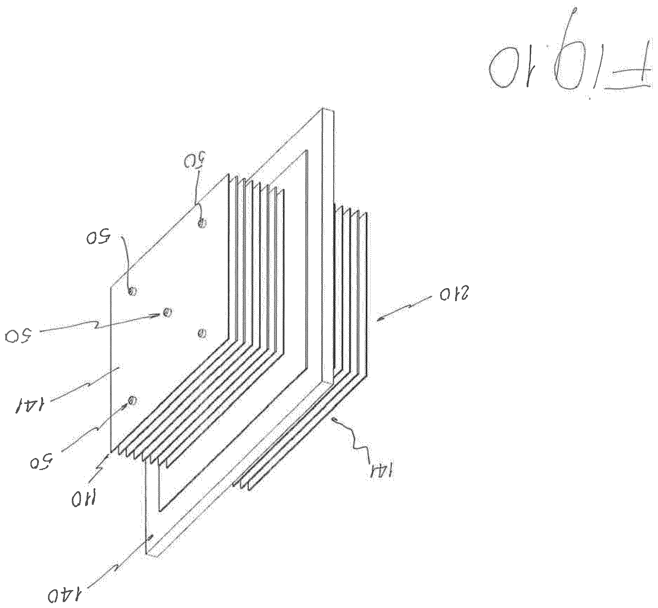

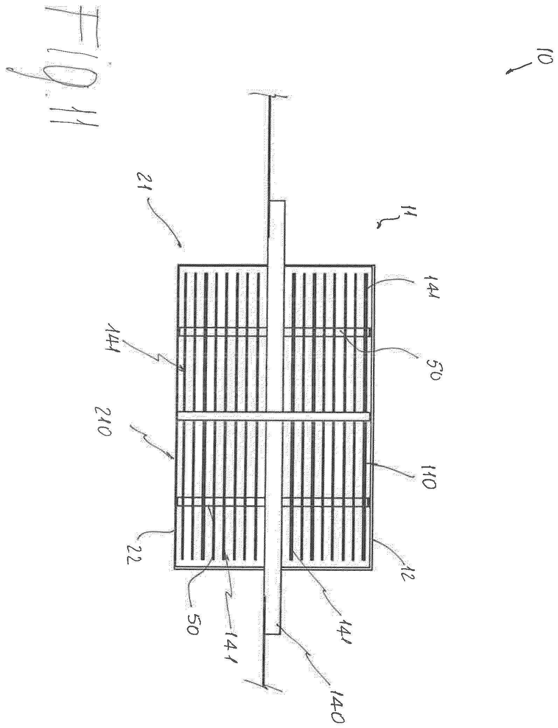

With reference to figures 10 and 11, in a particular embodiment of the invention, the first 11 thermal exchange assembly and/or the second thermal exchange assembly 21 comprise a plurality of heat pipes 50. In the embodiment shown, both the first 11 and the second 21 thermal exchange assembly are provided with heat pipes 50 in order to ensure a low thermal resistance between both sides.

In particular, in this embodiment, the first heat sink 110 and the second heat sink 210 comprises a plurality of fins 141 which are made of a thermal conductive material, e.g., aluminium, and which are positioned parallel to a common baseplate 140. Then, the heat pipes 50 are transversally positioned with respect to said plurality of fins 141 and cross both the first heat sink 110 and the second heat sink 210, as well as the common baseplate 140 which is interposed between them. Other arrangements of the fins 141 and of the heat pipes 50 are also possible, depending on the needs and the design of the thermal exchange device 10.

The first duct 12 of the first thermal exchange assembly 110 and the second duct 22 of the second thermal exchange assembly 110 can have different shapes and dimensions, depending on the operating needs. Also, their positioning relative to the enclosure 1 can be different according to the needs and convenience.

For instance, the first duct 12 of the first thermal exchange assembly 110 can be positioned substantially attached to a lateral wall, e.g., the rear wall 4 onto which the first heat sink 110 is attached, as shown in figures 1, 3, 4, and 6-8.

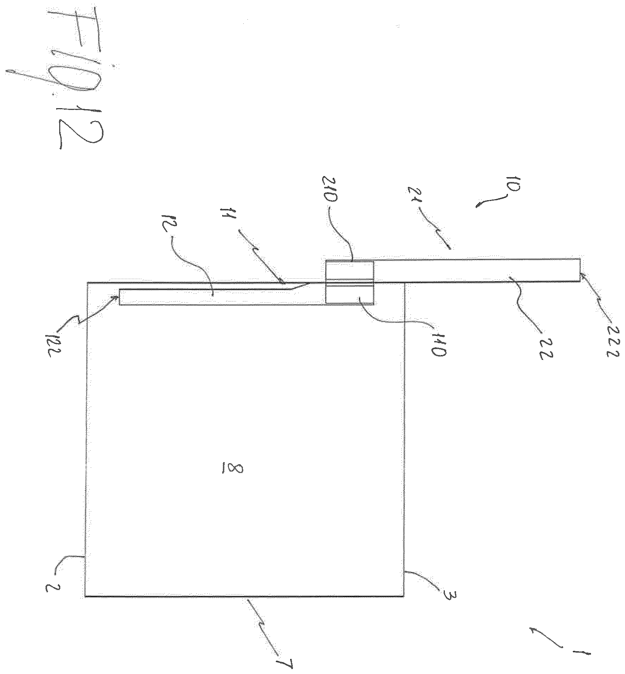

Alternatively, as shown in figure 12, in some embodiments of the present invention, the first duct 12 is at least partially positioned at a distance from the lateral wall 4, 5, 6, 7, e.g., the rear wall 4, onto which the first heat sink 110 is attached. In this way, the heat transfer area between the gas in the internal volume 8 of the enclosure 1 and the wall 4, 5, 6, 7 of the enclosure 1 can be maximized.

For instance, as shown in figure 12, the first duct 12 has a narrower cross section in the bottom part with respect to the top part in order to create a gap between its wall and the the rear wall 4 of the enclosure 1 for the reasons explained above.

Moreover, in the embodiment of figure 12 the outlet opening 122 of the first duct 12 has a narrower section with respect to the corresponding inlet opening 121 due to the difference of the first duct 12 cross section between its top and bottom parts.

More in general, such solution can be helpful in cases where the heat sink(s) and/or the duct(s) are relatively wide and is therefore desirable to narrow the section of the outlet opening(s) of the duct(s) in order to avoid inflow of surrounding gas/air through the outlet opening(s). From experiments carried out with the electrical enclosure as described above, it has been seen that the presently disclosed electrical enclosure can combine an effective reduction of the gas temperature inside the enclosure with the generation of a gas flow in the internal volume of the enclosure, which further improves cooling of the electrical equipment and components housed inside the enclosure.

The system of the present invention is particularly effective in gas insulated enclosures, and therefore a gas insulated switchgear is a specific object of the present invention
From a manufacturing standpoint, the presently disclosed electrical enclosure is very easy to manufacture with consequent advantages in terms of costs.

It is therefore clear from the above that the electrical enclosure of the present disclosure, fully meet the intended aims and purposes. Contingent shapes, materials, and dimensions can be any according to the needs and any variations in this respect shall be considered as part of the present invention.

## Claims

1. An electrical enclosure (1) comprising a base wall (2), a top wall (3) and a plurality of lateral walls (4, 5, 6, 7) which define an internal volume (8) of said enclosure (1), and further comprising a thermal exchange device (10), **characterized in that** said thermal exchange device (10) comprises a first thermal exchange assembly (11) positioned in said internal volume (8), wherein the first thermal exchange assembly (11) comprises a first heat sink (110) and a first duct (12) having an inlet opening (121) and an outlet opening (122), wherein the first heat sink (110) is fitted in the inlet opening (121) of said first duct (12), and wherein the first heat sink (110) is attached on one of said lateral walls (4, 5, 6, 7) in an upper half portion of the internal volume (8) of said enclosure (1) and the first duct (12) is directed downwardly with his outlet opening (122) positioned in a lower half portion of the internal volume (8) of said enclosure (1).

2. The electrical enclosure (1), according to claim 1, wherein said first heat sink (110) is attached on a top portion of one of said lateral walls (4, 5, 6, 7) at a distance from said top wall (3).

3. The electrical enclosure (1), according to claim 1 or 2, wherein the outlet opening (122) of said first duct (12) is positioned in the bottom of the internal volume (8) of said enclosure (1) at a distance from said base wall (2).

4. The electrical enclosure (1), according to one or more of the previous claims, wherein said first thermal exchange assembly (11) comprises a first thermal interface plate (13) positioned between said first heat sink (110) and the lateral wall (4, 5, 6, 7) onto which said first heat sink (110) is attached.

5. The electrical enclosure (1), according to one or more of the previous claims, wherein said first heat sink (110) comprises a plurality of fins (14, 141) made of a thermal conductive material.

6. The electrical enclosure (1), according to one or more of the previous claims, wherein the inlet opening (121) of said first duct (12) is tightly fitted around at least a portion of said first heat sink (110).

7. The electrical enclosure (1), according to one or more of the previous claims, **characterized in that** said the thermal exchange device (10) comprises a second thermal exchange assembly (21) positioned outside said electrical enclosure (1) and in thermal exchange with said first thermal exchange assembly (11).

8. The electrical enclosure (1), according to claim 7, wherein said second thermal exchange assembly (21) comprises a second heat sink (210) and a second duct (22) having an inlet opening (221) and an outlet opening (222).

9. The electrical enclosure (1), according to claim 8, wherein said second heat sink (210) is attached on the outer surface of the lateral wall (4, 5, 6, 7) onto which said first heat sink (110) is attached in a position matching the position of said first heat sink (110), and wherein said second duct (22) is directed upwardly.

10. The electrical enclosure (1), according to claim 7 or 8, wherein said second thermal exchange assembly (21) comprises a second thermal interface plate (131) positioned between said second heat sink (210) and the lateral wall (4, 5, 6, 7) onto which said second heat sink (210) is attached, and wherein said second heat sink (210) comprises a plurality of fins (14, 141) made of a thermal conductive material.

11. The electrical enclosure (1), according to one or more of claims 8-10, wherein one of said lateral walls (4, 5, 6, 7) of said enclosure (1) is provided with an opening, wherein said first (110) and second (210) heat sinks are positioned on opposite sides of a common baseplate (140), and wherein said common baseplate (140) is attached on the relevant lateral wall (4, 5, 6, 7) around said opening and closing said opening in a gas-tight way.

12. The electrical enclosure (1), according to one or more of the previous claims, wherein said first (11) and/or second (21) thermal exchange assembly comprise a plurality of heat pipes (50).

13. The electrical enclosure (1), according to one or more of the previous claims, wherein said first duct (12) is at least partially positioned at a distance from the lateral wall (4, 5, 6, 7) onto which said first heat sink (110) is attached.

14. The electrical enclosure (1), according to one or more of the previous claims, wherein the outlet opening(s) (122, 222) of said first (12) and/or second (22) duct(s) has a narrower section with respect to the corresponding inlet opening(s) (121, 221).

15. The electrical enclosure (1), according to one or more of the previous claims, **characterized in that** it is a gas insulated switchgear.
